# EUROPÄISCHE PATENTSCHRIFT

(11) **EP 2 887 781 B1**
(45) Veröffentlichungstag und Bekanntmachung des Hinweises auf die Patenterteilung: **09.06.2021**
(21) Anmeldenummer: 14195595.5
(22) Anmeldetag: 01.12.2014
(51) Int. Cl.: H05K 5/00, H05K 7/14

(54) **Elektrisches Gerät mit einem veränderbar ausgebildeten Gehäusevolumen**
Electrical device with a variable housing volume
Appareil électrique ayant un volume de boîtier modifiable

(30) Priorität: 16.12.2013 DE 102013226006
(43) Veröffentlichungstag der Anmeldung: 24.06.2015
(73) Patentinhaber: Robert Bosch GmbH, 70442 Stuttgart (DE)
(72) Erfinder: Hennel, Udo, 74343 Sachsenheim (DE); Meincke, Georg, 71229 Leonberg (DE)

(56) Entgegenhaltungen:
- WO-A1-2004/036972
- DE-A1-102008 040 501
- US-B1- 6 188 581

## Beschreibung

Die Erfindung betrifft ein elektrisches Gerät. Das elektrische Gerät weist ein Gehäuse auf und einen Schaltungsträger, insbesondere eine Leiterplatte. Das Gehäuse umschließt einen sich entlang einer Längsachse erstreckenden Hohlraum. Das Gehäuse ist ausgebildet, eine Leiterplatte - insbesondere vollständig - in dem Hohlraum aufzunehmen. Das Gehäuse weist wenigstens eine sich entlang der Längsachse erstreckende Nut auf, wobei die Nut ausgebildet ist, einen Leiterplattenrandabschnitt der Leiterplatte aufzunehmen, wobei der Leiterplattenrandabschnitt in der Nut gehalten ist.

### Stand der Technik

Bei den meisten elektrischen Geräten, bei denen eine Leiterplatte in einem Gehäuse aufgenommen ist, wird eine Größe, insbesondere ein Volumen eines von dem Gehäuse umschlossenen Hohlraums, an eine Größe der Leiterplatte angepasst. Somit sind für zueinander verschieden groß ausgebildete Leiterplatten zueinander verschiedene Gehäuse, mit zueinander verschiedenen Gehäusegrößen erforderlich.

In der Schrift US 6,188,581 B1 wird ein in der Größe variables Gehäuse zum Aufnehmen unterschiedlicher Leiterplattendimensionen für elektrische Sicherungen beschrieben, wobei die Größe des Gehäuses durch ein Verschieben eines äußeren Gehäuseelementes gegenüber einem Gehäusegrundelement eingestellt wird und die Fixierung der Halteposition durch ein Rastsystem erfolgt. In dem Gehäuse werden starre Leisten am Gehäusegrundelement zur Führung der Leiterplatte beschrieben.

### Austauschseite 1a

In der Schrift DE 10 2008 040 501 A1 wird ein Einschubgehäuse mit fester Gehäusegröße beschrieben. Das Einschubgehäuse weist eine Führungsrinne zur Aufnahme einer Leiterplatte auf. Die Leiterplatte wird von außen mit einer Steckerkulisse als Einschubgehäuseverschluss in die Führungsrinne des Einschubgehäuse eingeschoben. In der Führungsrinne kann die Leiterplatte von außen durch eine äußere Einprägung fixiert und randseitig eingeklemmt werden.

### Offenbarung der Erfindung

Erfindungsgemäß weist das Gehäuse der eingangs genannten Art einen Gehäusebecher auf. Der Gehäusebecher umfasst eine röhrenförmige, den Hohlraum umschließende Gehäusewand und einen Gehäusebecherboden. Der Gehäusebecherboden weist bevorzugt einen elektrischen Anschluss des Geräts auf. Der

Gehäusebecher weist eine Gehäuseöffnung zu dem Hohlraum hin auf, wobei das Gehäuse einen Verschlussbecher aufweist, welcher ausgebildet ist, entlang der Längsachse auf die Gehäusewand aufgeschoben oder hineingeschoben zu werden und dabei die Gehäuseöffnung zu verschließen. Bevorzugt überlappen die Gehäusewand und eine Wand des Verschlussbechers auf einem Abschnitt entlang der Längsachse einander. Das Gehäuse ist bevorzugt ausgebildet, dass der Verschlussbecher entlang der Längsachse zu Veränderungen eines Volumens des Hohlraums hin- und hergeschoben werden kann. So kann vorteilhaft das Volumen des Hohlraums für zueinander verschieden große Leiterplatten durch Verschieben des Verschlussbechers in eine vorbestimmte Verschlussposition verändert werden. Das Volumen, welches von dem Gehäuse eingeschlossen ist, ist bei der vorbestimmten Verschlussposition bevorzugt möglichst klein und hängt von der Größe der Leiterplatte ab. Die Leiterplatte ragt bevorzugt mit einem Endabschnitt aus der Gehäuseöffnung des Gehäusebechers heraus.

Bevorzugt ist der Verschlussbecher ausgebildet, beim Hineingeschoben- oder Aufgeschobenwerden auf die Gehäusewand die Gehäusewand zu umgreifen, beziehungsweise von der Gehäusewand umgriffen zu werden. Bevorzugt weist eine Öffnung des Verschlussbechers dazu einen größeren Durchmesser auf, als die röhrenförmige, den Hohlraum umschließende Gehäusewand, sodass der Verschlussbecher die Gehäusewand beim Aufgeschobenwerden umgreifen kann.

Der Verschlussbecher weist bevorzugt einen Boden auf, welcher weiter bevorzugt eine zu dem Gehäusebecherboden gegenüberliegende, weiter bevorzugt sich parallel erstreckende Gehäusewand bildet. So kann vorteilhaft mittels des bei Veränderung des Volumens des Hohlraums verschiebbar mit dem Gehäusebecher verbundenen Verschlussbechers das Gehäuse eine kastenähnliche Form aufweisen, wobei die Kastenform durch Verschieben des Verschlussbechers in ihrer Länge verändert werden kann. Vorteilhaft ist das Gehäuse im Bereich der Überlappung zwischen der röhrenförmigen Gehäusewand und der Wand des Verschlussbechers geschlossen. Weiter vorteilhaft können mittels des so ausgebildeten Gehäuses Leiterplatten mit zueinander verschiedenen Größen, mit demselben Gehäuse angeschlossen werden. Die Variation der Leiterplattenlänge entlang der Längsachse, insbesondere der Längenunterschied zwischen der längsten in dem Gehäuse einzuschließenden Leiterplatte und der kürzesten in dem Gehäuse einzuschließenden Leiterplatte entspricht dem Überlappungsbereich der Gehäusewand und der Wand des Verschlussbechers entlang der Längsachse.

Bevorzugt ist die Leiterplatte teilweise in dem von dem Gehäusebecher umschlossenen Hohlraum aufgenommen und ragt mit einem Endabschnitt aus dem Gehäusebecher heraus. Weiter bevorzugt ist der Endabschnitt in einem von dem Verschlussbecher umschlossenen Volumen aufgenommen.

Bevorzugt ist der Leiterplattenrandabschnitt der Leiterplatte in der Nut gehalten. Weiter bevorzugt bildet die Nut eine Schiene für den Leiterplattenrandabschnitt, in der die Leiterplatte entlang einer Längserstreckung der Nut verschoben werden kann. Dadurch kann die Leiterplatte einfach in den Gehäusebecher eingeschoben werden.

In einer bevorzugten Ausführungsform ist eine Gehäusequerschnittsform entlang einer Längserstreckung der Gehäusewand konstant. So kann der Verschlussbecher vorteilhaft bei einem Verschieben entlang der Längsachse, über den gesamten Überlappungsbereich mit dem Gehäusebecher abdichten.

Bevorzugt weist der Verschlussbecher, insbesondere im Bereich eines Öffnungsrandes, eine sich radial nach innen erstreckende Dichtung auf, welche ausgebildet ist, gegen die Gehäusewand des Gehäusebechers abzudichten. So kann das Gehäuse vorteilhaft vor eindringender Verschmutzung oder Feuchtigkeit geschützt sein.

In einer bevorzugten Ausführungsform weist das Gehäuse einen elektrischen Steckanschluss mit wenigstens einem elektrischen Steckkontakt auf. Der Steckanschluss ist bevorzugt in dem Boden des Gehäusebechers angeordnet oder bildet den Boden, wobei der wenigstens eine Steckkontakt durch den Boden des Gehäusebechers durchgeführt ist. So kann das Gehäuse vorteilhaft von außen elektrisch kontaktiert werden, wobei der Überlappungsbereich an der Gehäusewand vorteilhaft frei von nach außen weisenden elektrischen Anschlüssen bleiben kann, sodass der Verschlussbecher auf der Gehäusewand gleitend verschoben werden kann.

Bevorzugt ist der Gehäusebecher und/oder der Gehäuseboden durch ein Formteil, insbesondere ein Kunststoffteil, gebildet. Weiter bevorzugt ist der Steckanschluss in dem durch das Formteil gebildeten Gehäuseboden ausgebildet, insbesondere ausgeformt. So kann der Steckanschluss vorteilhaft mit dem Gehäuseboden, weiter bevorzugt gemeinsam mit der Gehäusewand mittels eines Spritzgusswerkzeugs als Formteil, insbesondere einstückiges Formteil, erzeugt werden.

Das Kunststoffteil ist bevorzugt durch einen Thermoplast, insbesondere Polyester, PBT oder PET (PBT= Polybutylenterephtalat, PET = Poly-Ethylen-Terephtalat), PPA (PPA = Poly-Phtal-Amid) oder ABS (ABS = Acrylnitril-Butadien-Styrol) gebildet.

In einer bevorzugten Ausführungsform erstreckt sich eine Steckrichtung des Steckkontakts entlang einer Längsrichtung des Gehäuses. So kann der Stecckontakt vorteilhaft platzsparend an dem Gehäuse ausgebildet sein.

In einer bevorzugten Ausführungsform ragt die Leiterplatte mit einem Endabschnitt aus der Gehäuseöffnung heraus. Der Verschlussbecher weist bevorzugt eine größere Tiefenerstreckung entlang der Längsachse auf, als der Endabschnitt, der aus der Gehäuseöffnung herausragt. So kann das Gehäuse vorteilhaft - bevorzugt unter Ausbildung des Überlappungsbereiches - mittels des Verschlussbechers verschlossen werden.

Bevorzugt bildet die Gehäusebecherwand in einem Querschnitt einen geschlossenen Kurvenzug. Dadurch ist durch die Gehäusebecherwand vorteilhaft eine gegenüber Feuchtigkeit dichte Röhre ausgebildet. Bevorzugt bildet die Wand des Verschlussbechers in einem Querschnitt einen geschlossenen Kurvenzug. Dadurch ist durch die Wand des Verschlussbechers vorteilhaft eine gegenüber Feuchtigkeit dichte Röhre ausgebildet.

In einer vorteilhaften Ausführungsform des Gehäuses ist der Gehäusebecher wenigstens teilweise durch zwei insbesondere im Querschnitt U-förmige Gehäuseschalen gebildet. Weiter bevorzugt sind die Gehäuseschalen miteinander verbunden, insbesondere schraubverbunden oder steckverbunden. Die Gehäuseschalen können beispielsweise zum miteinander Steckverbinden einen Rastverschluss, insbesondere einen Bajonettverschluss, aufweisen, sodass die Gehäuseschalen beim Aufeinanderstecken miteinander verrasten können.

In einer bevorzugten Ausführungsform weist die röhrenförmige Gehäusewand wenigstens eine Nut auf, welche ausgebildet ist, den Leiterplattenrand der Leiterplatte zu umgreifen, weiter bevorzugt nach Art einer Schiene zu führen. Bevorzugt ist eine die Nut umschließende Gehäusewand im Bereich der Nut U-förmig geformt. Der Verschlussbecher weist bevorzugt einen entsprechend der U-Form geformte Rinne auf, welche ausgebildet ist, den die Nut formenden Bereich der Gehäusewand wenigstens teilweise oder vollständig aufzunehmen. So kann die die Nut umschließende U-förmige Gehäusewand vorteilhaft in der Rinne nach Art einer Schiene beim Verschieben des Verschlussbechers auf dem Gehäusebecher geführt werden.

In einer bevorzugten Ausführungsform ist die Gehäusewand des Gehäusebechers derart elastisch ausgebildet, im Bereich der Nut - insbesondere unter Verengung der Nut - federnd verpresst zu werden. Die Wand des Verschlussbechers ist bevorzugt im Bereich eines Öffnungsrandes einer Öffnung des Verschlussbechers ausgebildet, die Gehäusewand, bevorzugt den Bereich der die Nut umschließenden Gehäusewand des Gehäusebechers, beim Zusammenschieben des Verschlussbechers und des Gehäusebechers - insbesondere im Bereich einer Überlappung der Gehäusewand mit der Wand des Verschlussbechers - derart zu verpressen, dass der Leiterplattenrand in der so verpressten Nut wenigstens kraftschlüssig festgehalten ist.

So braucht die Leiterplatte vorteilhaft nicht mittels gesonderter Befestigungsmittel in dem Gehäuse befestigt werden. Die Leiterplatte ist vorteilhaft in der Nut geführt und kann zum Einbringen in das Gehäuse in die Nut eingeschoben werden und dort geführt und gehalten werden. Zum Verschließen des Gehäuses kann der Verschlussbecher - unter Ausbildung des Überlappungsbereiches - auf den Gehäusebecher aufgeschoben werden. Der Verschlussbecher umschließt so den Endabschnitt der Leiterplatte, welcher aus der Öffnung des Gehäusebechers herausragt. Der Verschlussbecher, insbesondere die Rinne des Verschlussbechers, welche die Gehäusewand des Gehäusebechers im Bereich der Nut umgreift, kann beim Aufschieben die Gehäusewand im Bereich der Nut zusammenpressen, sodass die Leiterplatte in der Nut festgehalten ist.

Bevorzugt weist die Rinne des Verschlussbechers wenigstens auf einem Längsabschnitt eine kleinere Höhe auf, als eine Dickenerstreckung des U-förmig ausgebildeten Bereichs der Gehäusewand, welcher die Nut umschließt. Weiter bevorzugt ist der Verschlussbecher, insbesondere die Wand des Verschlussbechers, in der die Rinne ausgeformt ist, federnd elastisch ausgebildet. Dazu ist der Verschlussbecher beispielsweise durch einen Kunststoffbecher, insbesondere einen thermoplastischen Kunststoffbecher, beispielsweise aus Polyester, PBT oder PET (PBT= Polybutylenterephtalat, PET = Poly-Ethylen-Terephtalat), PPA (PPA = Poly-Phtal-Amid) oder ABS (ABS = Acrylnitril-Butadien-Styrol) gebildet.

Bevorzugt entspricht eine maximale Überlappung entlang der Längsachse, gebildet durch den Überlappungsbereich, wenigstens einer Erstreckung der röhrenförmigen Gehäusewand entlang der Längsachse. Weiter bevorzugt entspricht eine maximale Überlappung entlang der Längsachse zusätzlich der Längserstreckung des Steckanschlusses. Dadurch kann der Verschlussbecher zur Aufnahme einer kurzen Leiterplatte vollständig auf den Gehäusebecher aufgeschoben werden.

Die Erfindung betrifft auch ein Verfahren zum Erzeugen eines geschlossenen Gehäusehohlraums eines Gehäuses eines elektrischen Geräts. Bei dem Verfahren wird ein Verschlussbecher auf einen Gehäusebecher mit einer röhrenförmigen Gehäusewand entlang einer Längsachse aufgeschoben und dabei ein durch eine Gehäuseöffnung zugänglicher von dem Gehäusebecher umschlossener Hohlraum verschlossen, wobei ein Volumen des geschlossenen Gehäusehohlraums durch hin- und/oder Herschieben des Verschlussbechers entlang der Längsachse verändert werden kann.

Bevorzugt wird bei dem Hin- oder Herschieben eine Überlappung der Gehäusewand und einer Wand des Verschlussbechers verändert. Weiter bevorzugt entspricht eine maximale Überlappung entlang der Längsachse, gebildet durch den Überlappungsbereich, wenigstens einer Tiefe der röhrenförmigen Gehäusewand. Weiter bevorzugt entspricht eine maximale Überlappung zusätzlich einer Erstreckung des Steckanschlusses entlang der Längsachse. Der Verschlussbecher ist bei dieser maximalen Überlappung bis hin zum Gehäusebecherboden aufgeschoben. So kann ein Längenunterschied zwischen zwei in dem Gehäuse aufnehmbaren Leiterplatten durch die Tiefe des Gehäusebechers bestimmt sein.

Die Erfindung wird nun im Folgenden anhand von Figuren und weiteren Ausführungsbeispielen beschrieben. Weitere vorteilhafte Ausführungsvarianten ergeben sich aus den Merkmalen der Figuren und der abhängigen Ansprüche.
Figur 1 zeigt ein Ausführungsbeispiel für ein elektrisches Gerät mit einem Gehäuse, bei dem eine Gehäuseöffnung durch einen Verschlussbecher verschlossen werden kann;
Figur 2 zeigt das in Figur 1 dargestellte Gehäuse in einer Schnittdarstellung quer zu einer Längsachse des Gehäuses, entlang der der Verschlussbecher auf den Gehäusebecher aufgeschoben werden kann im Überlappungsbereich der Gehäusebecherwand mit der Wand des Verschlussbechers;
Figur 3 zeigt das in Figur 1 dargestellte elektrische Gerät in einer Längsschnittdarstellung, in der die Überlappung der Gehäusebecherwand mit der Wand des Verschlussbechers, und der dadurch veränderbar ausgebildete Hohlraum des Gehäuses ersichtlich wird.

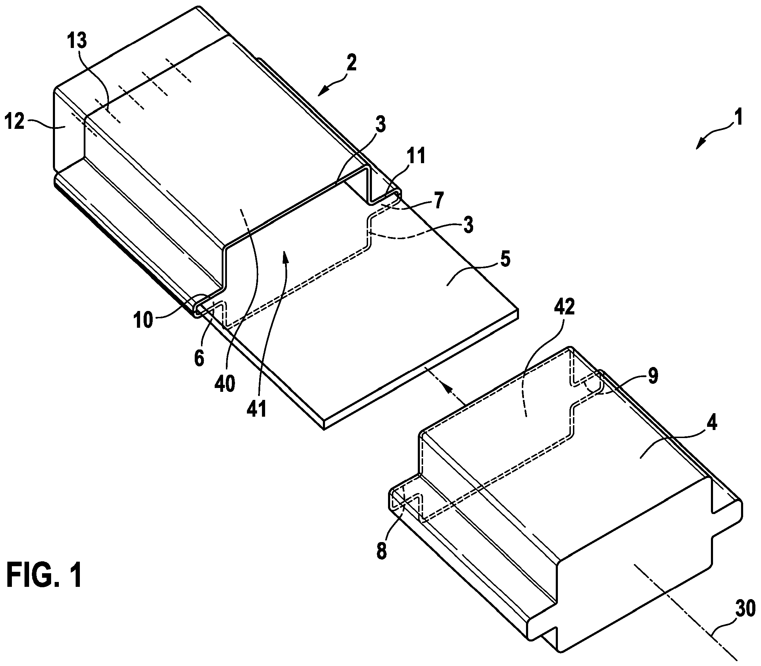

Figur 1 zeigt - schematisch - ein Ausführungsbeispiel für ein elektrisches Gerät mit einem Gehäuse 1. Das Gehäuse 1 weist einen Gehäusebecher 2 auf. Der Gehäusebecher 2 weist in diesem Ausführungsbeispiel eine röhrenförmige Gehäusebecherwand 3 auf. Die Gehäusebecherwand 3 umschließt in diesem Ausführungsbeispiel einen sich entlang einer Längsachse 30 längs erstreckenden Hohlraum 40.

Der Gehäusebecher 2 weist auch einen Gehäusebecherboden auf, welcher in diesem Ausführungsbeispiel durch ein einen Steckanschluss 12 bildendes Gehäuseteil gebildet ist. Der Steckanschluss 12 weist in diesem Ausführungsbeispiel mehrere elektrisch leitfähige Steckkontakte auf, von denen ein Steckkontakt 13 beispielhaft bezeichnet ist.

Die Gehäusewand 3 weist auch einen U-förmigen Bereich 10 auf, welcher eine Nut 6 im Inneren des Gehäusebechers 2 umschließt und einen U-förmigen Bereich 11 auf, welcher eine Nut 7 im Inneren des Gehäuses 1 umschließt. Die U-förmigen Bereiche 10 und 11 erstrecken sich jeweils entlang der Längsachse 30, wobei die Nut 7 und die Nut 6 jeweils ausgebildet sind, einen Leiterplattenrandabschnitt einer Leiterplatte 5 aufzunehmen. Die Leiterplatte 5 kann so entlang der Längsachse 30 in den Hohlraum 40 eingeschoben werden und wird dabei in der Nut 6 und der Nut 7 geführt.

Dargestellt ist auch eine Gehäuseöffnung 41 des Gehäusebechers 2 zu dem Hohlraum 40 hin.

Das Gehäuse 1 weist auch einen Verschlussbecher 4 auf, welcher ausgebildet ist, die Gehäuseöffnung 41 zu verschließen. Dazu kann der Verschlussbecher 4 entlang der Längsachse 30 auf die Gehäusewand 3 des Gehäusebechers 2 aufgeschoben werden. Der Verschlussbecher 4, insbesondere eine Wand des Verschlussbechers 4, ist dazu ausgebildet, die Gehäusewand 3 des Gehäusebechers 2 zu umgreifen, sodass beim Aufschieben des Verschlussbechers 4 auf dem Gehäusebecher 2 der Gehäusebecher 2 wenigstens mit einem Längsabschnitt entlang der Längsachse 30 in einem von dem Verschlussbecher 4 umschlossenen Hohlraum 42 aufgenommen werden kann.

Die Wand des Verschlussbechers 4 weist auch eine Rinne 8 und eine Rinne 9 auf. Die Rinne 8 ist ausgebildet, den U-förmigen Bereich 10 des Gehäusebechers 2 aufzunehmen und die Rinne 9 ist ausgebildet, den U-förmigen Bereich 11 des Gehäusebechers 2 aufzunehmen. Die Rinnen 8 und 9 erstrecken sich jeweils parallel zueinander entlang der Längsachse 30. Die Nut 6 und die Nut 7 erstrecken sich jedenfalls parallel zueinander zur Längsachse 30.

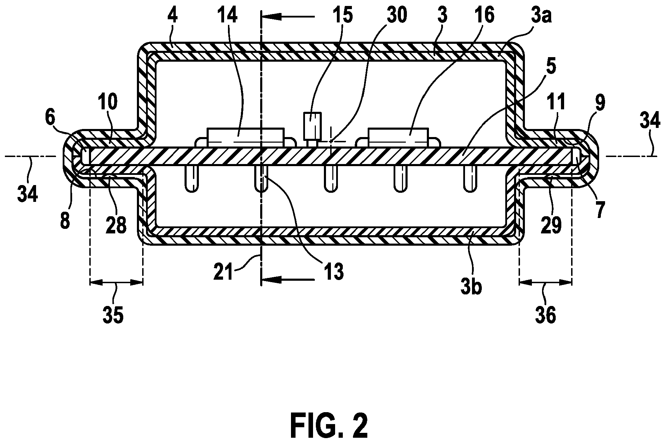

Figur 2 zeigt das in Figur 1 dargestellte Gehäuse 1 in einer Schnittdarstellung quer zur Längsachse 30, entlang der der Verschlussbecher 4 auf den Gehäusebecher aufgeschoben werden kann. Dargestellt ist die Gehäusebecherwand 3 des Gehäusebechers 2, welche in diesem Ausführungsbeispiel zwei im Querschnitt U-förmig geformte Gehäusebecherschalen 3a und 3b umfasst. Die Gehäusebecherschalen 3a und 3b sind in diesem Ausführungsbeispiel entlang einer Trennlinie 34 miteinander trennbar verbunden.

Anders als in Figur 2 dargestellt, kann der Gehäusebecher 2 als eine Röhre mit einer umlaufenden Gehäusebecherwand 3 ausgebildet sein. Der Gehäusebecher 2 kann beispielsweise so durch ein Strangpressprofil oder durch ein röhrenförmiges Spritzgussprofil gebildet sein.

Die Leiterplatte 5 weist in diesem Ausführungsbeispiel einen integrierten Schaltkreis 14, einen integrierten Schaltkreis 16 und ein elektronisches Bauelement 15, beispielsweise einen Kondensator, auf. Die Leiterplatte 5 ist mit einem Leiterplattenrandabschnitt 35 der Leiterplatte 5 in der Nut 6 geführt und gehalten, und mit einem dem Leiterplattenrandabschnitt 35 gegenüberliegenden Leiterplattenrandabschnitt 36 in der Nut 7 geführt und gehalten.

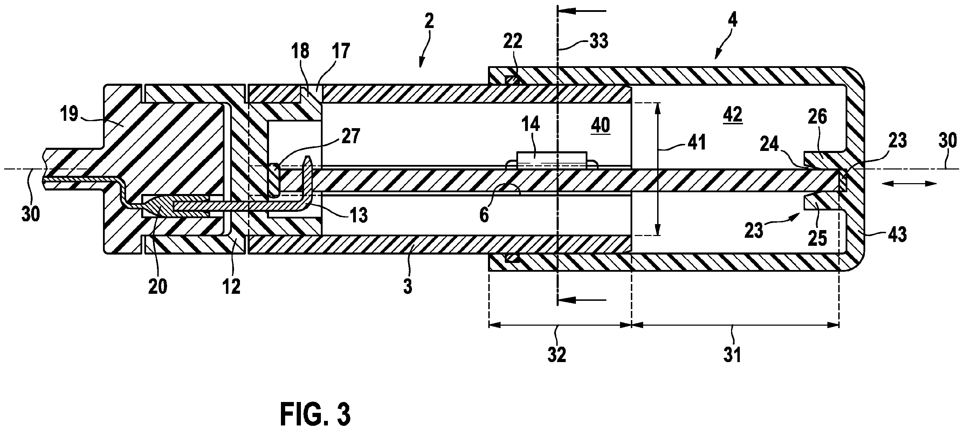

Dargestellt ist auch die Wand des Verschlussbechers 4, welche die Gehäusebecherwand 3 im Bereich eines in Figur 3 näher dargestellten Überlappungsbereichs 32 umschließt. Die Wand des Verschlussbechers 4 ist im Bereich der Rinne 8 ausgebildet, den Bereich 10 der Gehäusebecherwand 3 zu verpressen, sodass die Leiterplatte 5, insbesondere der Leiterplattenrandabschnitt 35, in der Nut 6 eingeklemmt ist. Dazu ist an die Wand des Verschlussbechers 4 ein Vorsprungsbereich 28 angeformt, welcher sich in der Rinne 8 erstreckt und welcher ausgebildet ist, den Bereich 10 der Gehäusebecherwand 3 federnd zu verpressen. Die Wand des Verschlussbechers 4 weist auch einen Vorsprungsbereich 29 auf, welcher an die Wand des Verschlussbechers 4 im Bereich der Rinne 9 angeformt ist und sich in die Rinne 9 hinein erstreckt und ausgebildet ist, den Bereich 11 der Gehäusebecherwand 3 federnd zu verpressen, sodass die Leiterplatte 5, insbesondere der Leiterplattenrandabschnitt 36 der Leiterplatte 5, in der Nut 7 festgehalten ist.

Figur 3 zeigt eine Schnittdarstellung des in Figur 1 dargestellten Gehäuses entlang einer in Figur 2 dargestellten Schnittlinie 21. Eine Schnittlinie 33 kennzeichnet den Schnitt zu Figur 2.
Die Leiterplatte 5 ist mit einem Längsabschnitt entlang der Längsachse 30 in dem Hohlraum 40 des Gehäusebechers 2 angeordnet und schlägt mit einer Stirnseite gegen den Gehäusebecherboden, welcher durch den Steckanschluss 12 gebildet ist, gefedert an. Dazu ist zwischen der Stirnseite der Leiterplatte 5 und dem Steckanschluss 12 ein elastisch ausgebildetes Federelement 27, beispielsweise ein Silikongummielement, angeordnet.

Die Gehäusebecherwand 3 weist im Bereich des Steckanschlusses 12 eine Aussparung 17 auf, welche ausgebildet ist, einen Bajonetthaken 18 wenigstens teilweise aufzunehmen. Der Bajonetthaken 18 ist in diesem Ausführungsbeispiel an den Steckanschluss 12 angeformt und erstreckt sich in den Hohlraum 40 hinein. Die Gehäusebecherwand 3 des Gehäusebechers 2 kann so auf den Steckanschluss 12 aufgeschoben werden, sodass eine zu der Öffnung 41 gegenüberliegende Öffnung der röhrenförmigen Gehäusebecherwand 3 liegende Öffnung durch den Steckanschluss 12 verschlossen werden kann und so der Steckanschluss 12 den Gehäusebecherboden des Gehäusebechers 2 bildet.

Dargestellt ist auch ein Stecker 19, welcher ausgebildet ist, mit dem Steckanschluss 12 steckverbunden zu werden. Dazu weist der Stecker 12 einen Gegensteckkontakt 20 auf, welcher ausgebildet ist, mit dem Steckkontakt 13 zum Erzeugen einer elektrisch leitfähigen Verbindung zwischen dem Gegensteckkontakt 20 und dem Steckkontakt 13, steckverbunden zu werden. Der Steckkontakt 13 ist in diesem Ausführungsbeispiel in den Hohlraum 40 hineingeführt und mit der Leiterplatte 5 elektrisch verbunden.

Der Verschlussbecher 4 ist in diesem Ausführungsbeispiel auf die Gehäusebecherwand 3 des Gehäusebechers 2 aufgeschoben und bildet gemeinsam mit der Gehäusebecherwand 3 entlang der Längsachse 30 einen Überlappungsbereich 32. Der Verschlussbecher 4 weist im Bereich eines Öffnungsrandes des Verschlussbechers 4 eine elastisch ausgebildete Dichtung 22 auf, welche ausgebildet ist, den Verschlussbecher 4 gegen die Gehäusebecherwand 3 abzudichten. Der Verschlussbecher 4 kann entlang der Längsachse 30 in dem Überlappungsbereich 32 hin- und hergeschoben werden, sodass das von dem Gehäuse 1 umschlossene Volumen des Hohlraums, gebildet durch die Hohlräume 40 und 42, veränderbar ausgebildet ist.

Der Verschlussbecher 4 weist im Bereich eines Verschlussbecherbodens 43 des Verschlussbechers 4 eine Aufnahme 24 für einen Leiterplattenrand der Leiterplatte 5 auf. Die Aufnahme 24 erstreckt sich zwischen zwei Vorsprungsbereichen 25 und 26, welche sich jeweils in den Hohlraum 42 des Verschlussbechers hinein erstrecken und welche ausgebildet sind, den Leiterplattenrand der Leiterplatte 5 aufzunehmen. Die Leiterplatte 5 ist so in der Aufnahme 24 gehalten.

Die Aufnahme 24 des Verschlussbechers 4 ist so ausgebildet, die Leiterplatte 5 gegen das Federelement 27, und so gegen den mittels des Steckkontakts 12 gebildeten Gehäusebecherboden des Gehäusebechers 2 zu pressen. Zusätzlich kann ein elastisch ausgebildetes Element 23 in der Aufnahme 24 angeordnet sein, so dass die Leiterplatte 5 zwischen dem elastisch ausgebildeten Federelement 23 und dem Federelement 27 gefedert gelagert ist.

Die Leiterplatte 5 ragt mit einem Längsabschnitt 31 aus dem Gehäusebecher 2 heraus. Der Längsabschnitt 31 ist in dem von dem Gehäusebecher 4 umschlossenen Hohlraum 42 eingeschlossen, und so vor Feuchtigkeit und Verschmutzung geschützt.

## Patentansprüche

1. Elektrisches Gerät mit einem Gehäuse (1) und einer Leiterplatte (5), wobei das Gehäuse (1) einen sich entlang einer Längsachse (30) erstreckenden Hohlraum (40, 42) umschließt und ausgebildet ist, eine Leiterplatte (5) in dem Hohlraum aufzunehmen und das Gehäuse (1) wenigstens eine sich entlang der Längsachse ersteckende Nut (6, 7) aufweist, welche ausgebildet ist, einen Leiterplattenrandabschnitt (35, 36) der Leiterplatte (5) aufzunehmen, wobei das Gehäuse (1) einen Gehäusebecher (2) umfassend eine röhrenförmige, den Hohlraum umschließende Gehäusewand (3) und einen Gehäusebecherboden (12) aufweist, wobei der Gehäusebecher (3) eine Gehäuseöffnung (41) zu dem Hohlraum (40) hin aufweist, und das Gehäuse (1) einen Verschlussbecher (4) aufweist, welcher ausgebildet ist, entlang der Längsachse (30) auf die Gehäusewand (3) aufgeschoben oder hineingeschoben zu werden und die Gehäuseöffnung (41) zu verschließen, wobei die Gehäusewand (3) mit einer Wand des Verschlussbechers (4) auf einem Abschnitt (32) entlang der Längsachse (30) einander überlappen, wobei der Verschlussbecher (4) entlang der Längsachse (30) zur Veränderung eines Volumens des Hohlraums (40, 42) hin- und/oder hergeschoben werden kann,
**dadurch gekennzeichnet, dass**
die röhrenförmige Gehäusewand (3) wenigstens eine Nut (6, 7) aufweist, welche ausgebildet ist, den Leiterplattenrandabschnitt (35, 36) der Leiterplatte (5) zu umgreifen, wobei eine die Nut (6, 7) umschließende Gehäusewand (3) im Bereich (10, 11) der Nut (6, 7) U-förmig geformt ist, und der Verschlussbecher (4) eine entsprechend der U-Form geformte Rinne (8, 9) aufweist, welche ausgebildet ist, den die Nut formenden Bereich (10, 11) der Gehäusewand (3) wenigstens teilweise aufzunehmen und wobei die Gehäusewand (3) des Gehäusebechers (2) im Bereich (10, 11) der Nut (6, 7) derart elastisch ausgebildet ist, federnd verpresst zu werden, wobei die Wand des Verschlussbechers (4) wenigstens im Bereich eines Öffnungsrandes einer Öffnung ausgebildet ist, den Bereich (10, 11) der die Nut (6, 7) umschließenden Gehäusewand (3) des Gehäusebechers (2) beim Zusammenschieben des Verschlussbechers (4) und des Gehäusebechers derart zu verpressen, dass die Nut (6, 7) durch die Verpressung der elastischen Gehäusewand (3) des Gehäusebechers (2) im Bereich (10, 11) verengt wird und, dass der Leiterplattenrandabschnitt (35, 36) in der so verpressten Nut (6, 7) wenigstens kraftschlüssig festgehalten ist..

2. Gehäuse (1) nach Anspruch 1, **dadurch gekennzeichnet, dass** eine Gehäusequerschnittsform entlang einer Längserstreckung der Gehäusewand (3) konstant ist.

3. Gehäuse (1) nach Anspruch 1 oder 2, **dadurch gekennzeichnet, dass** das Gehäuse (1) einen elektrischen Steckanschluss (12) mit wenigstens einem elektrischen Steckkontakt (13) aufweist, wobei der Steckanschluss (12) in dem Boden des Gehäusebechers (3) angeordnet ist oder den Boden bildet und der wenigstens eine Steckkontakt (13) durch den Boden durchgeführt ist.

4. Gehäuse (1) nach Anspruch 3, **dadurch gekennzeichnet, dass** die Leiterplatte (5) mit einem Endabschnitt (31) aus der Gehäuseöffnung (41) herausragt.

5. Gehäuse (1) nach einem der vorhergehenden Ansprüche, **dadurch gekennzeichnet, dass** der Gehäusebecher (2) wenigstens teilweise durch zwei - insbesondere im Querschnitt U-förmige - Gehäuseschalen (3A, 3B) gebildet ist, welche miteinander verbunden, insbesondere steckverbunden sind.

6. Gehäuse (1) einem der vorhergehenden Ansprüche, **dadurch gekennzeichnet, dass** die Rinne (8, 9) des Verschlussbechers (4) wenigstens auf einem Längsabschnitt eine kleinere Höhe aufweist als eine Dickenerstreckung des U-förmig ausgebildeten Bereichs (10, 11) der Gehäusewand (3).

7. Gehäuse (1) nach einem der vorhergehenden Ansprüche, **dadurch gekennzeichnet, dass** eine maximale Überlappung entlang der Längsachse, gebildet durch den Überlappungsbereich (32), wenigstens einer Erstreckung der röhrenförmigen Gehäusewand (3) entlang der Längsachse (30) entspricht.

## Claims

1. Electrical device having a housing (1) and a printed circuit board (5), wherein the housing (1) encloses a hollow space (40, 42) extending along a longitudinal axis (30) and is designed to receive a printed circuit board (5) in the hollow space and the housing (1) has at least one groove (6, 7) extending along the longitudinal axis, which groove is designed to receive a printed circuit board edge section (35, 36) of the printed circuit board (5), wherein the housing (1) has a housing cup (2) comprising a tubular housing wall (3) enclosing the hollow space and has a housing cup base (12), wherein the housing cup (3) has a housing opening (41) towards the hollow space (40), and the housing (1) has a closure cup (4) which is designed to be pushed onto or into the housing wall (3) along the longitudinal axis (30) and to close the housing opening (41), wherein the housing wall (3) and a wall of the closure cup (4) overlap with one another in a section (32) along the longitudinal axis (30), wherein the closure cup (4) can be pushed to and/or fro along the longitudinal axis (30) for the purpose of changing a volume of the hollow space (40, 42),
**characterized in that**
the tubular housing wall (3) has at least one groove (6, 7) which is designed to engage around the printed circuit board edge section (35, 36) of the printed circuit board (5), wherein a housing wall (3) enclosing the groove (6, 7) is formed in a U-shape in the region (10, 11) of the groove (6, 7), and the closure cup (4) has a channel (8, 9) which is formed in a manner corresponding to the U-shape and is designed to at least partially receive the region (10, 11), forming the groove, of the housing wall (3) and wherein the housing wall (3) of the housing cup (2) is of elastic design in the region (10, 11) of the groove (6, 7) in such a way as to be compressed in a resilient manner, wherein the wall of the closure cup (4) is formed at least in the region of an opening edge of an opening to compress the region (10, 11) of the housing wall (3), enclosing the groove (6, 7), of the housing cup (2), when the closure cup (4) and the housing cup are pushed together, in such a way that the groove (6, 7) is constricted by the compression of the elastic housing wall (3) of the housing cup (2) in the region (10, 11), and **in that** the printed circuit board edge section (35, 36) is at least non-positively firmly held in the groove (6, 7) compressed in this way.

2. Housing (1) according to Claim 1, **characterized in that** a housing cross-sectional shape along a longitudinal extent of the housing wall (3) is constant.

3. Housing (1) according to Claim 1 or 2, **characterized in that** the housing (1) has an electrical plug-in connection (12) with at least one electrical plug-in contact (13), wherein the plug-in connection (12) is arranged in the base of the housing cup (3) or forms the base and the at least one plug-in contact (13) is routed through the base.

4. Housing (1) according to Claim 3, **characterized in that** the printed circuit board (5), by way of an end section (31), protrudes out of the housing opening (41).

5. Housing (1) according to one of the preceding claims, **characterized in that** the housing cup (2) is at least partially formed by two housing shells (3A, 3B) - in particular of U-shape in cross section - which are connected, in particular plug-connected, to one another.

6. Housing (1) according to one of the preceding claims, **characterized in that** the channel (8, 9) of the closure cup (4), at least in a longitudinal section, has a smaller height than a thickness extent of the U-shaped region (10, 11) of the housing wall (3).

7. Housing (1) according to one of the preceding claims, **characterized in that** a maximum overlap along the longitudinal axis, formed by the overlap region (32), corresponds at least to an extent of the tubular housing wall (3) along the longitudinal axis (30).

## Revendications

1. Appareil électrique comprenant un boîtier (1) et une carte de circuits imprimés (5), dans lequel le boîtier (1) entoure une cavité (40, 42) s'étendant le long d'un axe longitudinal (30) et est réalisé pour recevoir une carte de circuits imprimés (5) dans la cavité, et le boîtier (1) présente au moins une rainure (6, 7) s'étendant le long de l'axe longitudinal et qui est réalisée pour recevoir une partie de bord de carte de circuits imprimés (35, 36) de la carte de circuits imprimés (5), dans lequel le boîtier (1) présente un compartiment de boîtier (2) comprenant une paroi de boîtier tubulaire (3) entourant la cavité, et un fond de compartiment de boîtier (12), le compartiment de boîtier (3) présentant une ouverture de boîtier (41) vers la cavité (40), et le boîtier (1) présentant un compartiment de fermeture (4) qui est réalisé pour être poussé le long de l'axe longitudinal (30) sur ou dans la paroi de boîtier (3), et pour fermer l'ouverture de boîtier (41), dans lequel la paroi de boîtier (3) se chevauche avec une paroi du compartiment de fermeture (4) sur une partie (32) le long de l'axe longitudinal (30), le compartiment de fermeture (4) pouvant être poussé dans les deux sens le long de l'axe longitudinal (30) pour modifier un volume de la cavité (40, 42),
**caractérisé en ce que**
la paroi de boîtier tubulaire (3) présente au moins une rainure (6, 7) qui est réalisée pour saisir la partie de bord de carte de circuits imprimés (35, 36) de la carte de circuits imprimés (5), une paroi de boîtier (3) entourant la rainure (6, 7) étant formée en forme de U dans la zone (10, 11) de la rainure (6, 7), et le compartiment de fermeture (4) présentant une gorge (8, 9) formée selon la forme de U et qui est réalisée pour recevoir au moins en partie la zone (10, 11), formant la rainure, de la paroi de boîtier (3), et dans lequel la paroi de boîtier (3) du compartiment de boîtier (2) est réalisée dans la zone (10, 11) de la rainure (6, 7) élastiquement de telle sorte qu'elle est comprimée en faisant ressort, la paroi du compartiment de fermeture (4) étant réalisée au moins au niveau d'un bord d'ouverture d'une ouverture pour comprimer la zone (10, 11) de la paroi de boîtier (3), entourant la rainure (6, 7), du compartiment de boîtier (2) pendant que le compartiment de fermeture (4) et le compartiment de boîtier sont poussés ensemble de telle sorte que la rainure (6, 7) est rétrécie par la compression de la paroi de boîtier élastique (3) du compartiment de boîtier (2) dans la zone (10, 11), et que la partie de bord de carte de circuits imprimés (35, 36) est retenue au moins par adhérence dans la rainure (6, 7) ainsi comprimée.

2. Boîtier (1) selon la revendication 1, **caractérisé en ce qu'**une forme de section transversale de boîtier est constante le long d'une dimension longitudinale de la paroi de boîtier (3).

3. Boîtier (1) selon la revendication 1 ou 2, **caractérisé en ce que** le boîtier (1) présente une connexion enfichable électrique (12) dotée d'au moins un contact enfichable électrique (13), la connexion enfichable (12) étant disposée dans le fond du compartiment de boîtier (3) ou formant le fond et ledit au moins un contact enfichable (13) étant amené à travers le fond.

4. Boîtier (1) selon la revendication 3, **caractérisé en ce que** la carte de circuits imprimés (5) dépasse de l'ouverture de boîtier (41) par une partie d'extrémité (31) .

5. Boîtier (1) selon l'une quelconque des revendications précédentes, **caractérisé en ce que** le compartiment de boîtier (2) est formé au moins en partie par deux coques de boîtier (3A, 3B), en particulier à section transversale en forme de U, qui sont reliées l'une à l'autre, en particulier reliées par emboîtement.

6. Boîtier (1) selon l'une quelconque des revendications précédentes, **caractérisé en ce que** la gorge (8, 9) du compartiment de fermeture (4) présente au moins sur une partie longitudinale une hauteur inférieure à une dimension d'épaisseur de la zone réalisée (10, 11), en forme de U, de la paroi de boîtier (3).

7. Boîtier (1) selon l'une quelconque des revendications précédentes, **caractérisé en ce qu'**un chevauchement maximal le long de l'axe longitudinal, formé par la zone de chevauchement (32), correspond au moins à une extension de la paroi de boîtier tubulaire (3) le long de l'axe longitudinal (30).
